# EUROPÄISCHE PATENTSCHRIFT

(11) **EP 0 856 772 B1**
(45) Veröffentlichungstag und Bekanntmachung des Hinweises auf die Patenterteilung: **05.06.2002**
(21) Anmeldenummer: 98100783.4
(22) Anmeldetag: 17.01.1998
(51) Int. Cl.: G03F 7/033, G03F 7/075, B41M 1/00, B41M 1/04

(54) **Photopolymerisierbares Gemisch zur Herstellung von flexographischen Druckformen für den Wellpappendruck**
Photopolymerizable composition for the production of flexographic printing forms for corrugated board printing
Composition photopolymerisable pour la préparation des clichés flexographiques pour l'impression de carton ondulé

(30) Priorität: 03.02.1997 DE 19703917
(43) Veröffentlichungstag der Anmeldung: 05.08.1998
(73) Patentinhaber: DU PONT DE NEMOURS (DEUTSCHLAND) GMBH, 61343 Bad Homburg v.d.H. (DE); E.I. DU PONT DE NEMOURS AND COMPANY, Wilmington Delaware 19898 (US)
(72) Erfinder: Kraska, Ursula, Dr., 64331 Weiterstadt (DE); Simon, Reimund, 63633 Birstein (DE)

(56) Entgegenhaltungen:
- EP-A- 0 696 761
- WO-A-95/08136
- DE-C- 4 022 978
- US-A- 4 197 130
- US-A- 5 422 225

## Beschreibung

Die Erfindung betrifft ein photopolymerisierbares Gemisch enthaltend elastomere Bindemittel, photopolymerisierbare, ethylenisch ungesättigte Verbindungen und Photoinitiatoren, eine photopolymerisierbare Druckplatte umfassend mindestens eine photopolymerisierbare Schicht aus solch einem Gemisch und eine daraus hergestellte flexographische Druckform.

Es ist bekannt, für die Herstellung von flexographischen Druckformen photopolymerisierbare Druckplatten zu verwenden, bei denen die Druckoberfläche durch bildmäßiges Belichten einer durch aktinische Strahlung photopolymerisierbaren Schicht und anschließendes Entfernen der unbelichteten, nicht photopolymerisierten Druckplattenbereiche erzeugt wird. Beispiele hierfür finden sich in den folgenden Patenten: DE-C 22 15 090, US-A 4,266,005; US-A 4,320,188; US-A 4,126,466 und US-A 4,430,417.

Solche photopolymerisierbaren Druckplatten setzen sich üblicherweise aus einem Schichtträger, ggf. einer Haft- oder anderen Unterschicht, einer oder mehreren photopolymerisierbaren Schichten, ggf. einer elastomeren Zwischenschicht und einer Deckschicht zusammen.

Eine bevorzugte Methode zur Herstellung solcher mehrschichtigen, photopolymerisierbaren Druckplatten ist ein Verfahren, bei dem in den Spalt eines Kalanders eine vorher extrudierte, photopolymerisierbare Masse eingeführt und zwischen einen Träger und ein Deckelement kalandriert wird, wodurch eine photopolymerisierbare Schicht zwischen ihnen gebildet wird. Aus der EP-B 0 084 851 ist ein Herstellungsverfahren für eine mehrschichtige, photopolymerisierbare Druckplatte bekannt, die zwischen der flexiblen, reißfesten Polymerschicht und der photopolymerisierbaren Schicht eine weitere elastomere Schicht besitzt.

Die photopolymerisierbaren Schichten enthalten polymere Bindemittel, photopolymerisierbare Monomere, Photoinitiatoren und weitere Hilfsstoffe wie Weichmacher, Füllstoffe, Stabilisatoren, u.s.w. Als polymere Bindemittel werden üblicherweise thermoplastisch elastomere Blockcopolymere verwendet, wie sie in der DE-C 22 15 090 beschrieben sind. Dies sind im allgemeinen A-B-A Blockcopolymere mit thermoplastischen Blöcken A und elastomeren Blöcken B, insbesondere lineare und radiale Blockcopolymere mit Polystyrolendblöcken wie z.B. Polystyrol-Polyisopren-Polystyrol, (Polystyrol-Polyisopren)₄Si oder die entsprechenden Butadienpolymere.

Häufig entsprechen jedoch die nach dem Stand der Technik hergestellten Druckplatten und -formen nicht allen Anforderungen. Vor allem bei der Verwendung im Wellpappendirektdruck treten immer wieder Schwierigkeiten auf. Die hierfür verwendeten Tiefreliefformen müssen einerseits eine hohe Kohäsion innerhalb des Photopolymers aufweisen, um ein Ausbrechen der Rasterpunkte, besonders der freistehenden Rasterpunkte, zu vermeiden und sie sicher auf der Druckform zu verankern. Das gleiche gilt für feine Linien, die zusätzlich nicht wellig abgebildet werden dürfen. Gleichzeitig müssen die Druckformen weich genug sein, um den "Waschbretteffekt" auf Volltonflächen zu vermeiden. Ein unterschiedlich kompressibles Wellenprofil und sehr rauhe Bedruckstoffe, wie die häufig verwendeten Recyclingpapiere, erschweren zudem eine gleichmäßige Farbübertragung. Die Herstellung von Druckformen, die diese Kombination von Tiefrelief, stabilen Rasterpunkten und -linien, gute Farbübertragung und der erforderlichen Weichheit für gute Vollflächenwiedergabe aufweisen, ist oft aufwendig und die Reproduzierbarkeit der Platteneigenschaften ist nicht sehr gut. Vor allem neigen die Druckplatten des Standes der Technik sehr häufig zu kaltem Fluß, so daß ihre Lagerung und Handhabung erschwert sind.

Der vorliegenden Erfindung lag daher die Aufgabe zugrunde, flexographische Druckformen, insbesondere zur Verwendung im Wellpappendirektdruck, zur Verfügung zu stellen, die die beschriebenen Nachteile der Druckformen des Standes der Technik nicht aufweisen, und die photopoplymerisierbaren Druckplatten zur Herstellung dieser flexographischen Druckformen sollen eine erhöhte Photoempfindlichkeit aufweisen, ohne daß andere wesentliche Eigenschaften der photopolymerisierbaren Druckplatten oder der flexographischen Druckformen negativ beeinflußt werden.

Diese Aufgabe wurde überraschenderweise gelöst durch ein photopolymerisierbares Gemisch und eine photopolymerisierbare Druckplatte enthaltend mindestens ein elastomeres Bindemittel, mindestens eine photopolymerisierbare, ethylenisch ungesättigte Verbindung, mindestens einen Photoinitiator oder ein Photoinitiatorsystem, dadurch gekennzeichnet, daß es mindestens ein radiales (Polystyrol-Polybutadien)ₙX Blockcopolymer, mit X = Sn oder Si und n = 4, enthält, das ein mittleres Molekulargewicht (M_{w}) von 80 000 - 300 000, eine Molekulargewichtsverteilung (M_{w}/Mₙ) von 1.00 - 1.40 und einem Diblockcopolymer gehalt von > 0 - 15 Gew.-% aufweist und mit > 0 - 50 Gew.-% mindestens eines Paraffinöls verstreckt ist, und eine hieraus hergestellte flexographische Druckform.

Überraschenderweise wird durch den Einsatz der erfindungsgemäßen Polymere der Herstellungsprozeß von photopolymerisierbaren Druckplatten vereinfacht, und es werden stabilere Produkte erhalten mit besserer Reproduzierbarkeit der für den Wellpappendirektdruck erforderlichen Eigenschaften der Druckplatten bzw. -formen. Außerdem wird auch die Photoempfindlichkeit von photopolymerisierbaren Druckplatten erhöht, so daß kürzere Belichtungszeiten sowohl für die bildmäßige Hauptbelichtung als auch für die vollflächige Rückseitenbelichtung möglich sind. Ein besonderer Vorteil der erfindungsgemäßen Materialien ist eine hohe Shore A Härte der noch nicht photopolymerisierten Druckplatten und gleichzeitig eine niedrige Shore A Härte der fertigen Druckformen im Vergleich zu Druckplatten und -formen des Standes der Technik. Die erfindungsgemäßen photopolymerisierbaren Druckplatten zeigen somit einen geringeren kalten Fluß als Druckplatten des Standes der Technik, ohne daß die erforderliche Weichheit der Druckformen verloren geht. Die Shore A Härte des nicht-photopolymerisierten Gemischs bzw. der Druckplatte ist ≥ 20, die des photopolymerisierten Gemischs bzw. der Druckform ist ≤ 40, bevorzugt ≤ 38 und die Differenz zwischen den Shore A Härten des photopolymerisierten Materials und des nicht-photopolymerisierten Materials ist ≤ 22, bevorzugt ≤ 20. Desweiteren zeigen die aus den erfindungsgemäßen Materialien hergestellten Druckformen eine gute Farbübertragung.

Als erfindungswesentliche Polymere werden radiale (Polystyrol-Polybutadien)ₙX Blockcopolymere mit X = Sn oder Si und n = 4 verwendet, bevorzugt werden (Polystyrol-Polybutadien)₄Si Blockcopolymere eingesetzt. Die erfindungsgemäßen Polymere haben einen mittleres Molekulargewicht (M_{w}) von 80 000 - 300 000, bevorzugt 100 000 - 250 000, und eine Molekulargewichtsverteilung (M_{w}/Mₙ) von 1.00 - 1.40, bevorzugt 1.00 - 1.25. Die erfindungswesentlichen Polymere enthalten > 0 - 15 Gew.-% an Diblockcopolymeren, bevorzugt > 0 - 10 Gew.-%. Zudem sind die Polymere mit > 0 - 50 Gew.-%, bevorzugt 25 - 40 Gew.-%, eines oder mehrerer Paraffinöle verstreckt. Diese Paraffinöle enthalten bevorzugt weniger als 10 Gew.-% aromatischer Verbindungen. Der Polystyrolgehalt der erfindungswesentlichen Polymere beträgt 10 bis 40 Gew.-%, bevorzugt 15 - 35 Gew.-%. Insbesondere (Polystyrol-Polybutadien)₄Si Blockcopolymere mit einem mittleren Molekulargewicht (M_{w}) von 150 000 - 200 000, einem Diblockpolymergehalt von < 10 Gew.-% und 25 - 35 Gew.-% Paraffinöl werden bevorzugt verwendet.

Bevorzugt werden die erfindungsgemäßen Blockcopolymere als alleinige Bindemittel eines photopolymerisierbaren Gemischs bzw. einer photopolymerisierbaren Druckplatte verwendet. Sie können aber auch als Mischungen mit anderen thermoplastisch elastomeren Blockcopolymeren eingesetzt werden, falls besondere Anforderungen an die Platteneigenschaften dies erfordern. Die Menge der erfindungswesentlichen Polymere beträgt in diesem Fall nicht weniger als 30 Gew.-%, bevorzugt ≥ 50 Gew.-%, besonders bevorzugt ≥ 70 Gew.-%, bezogen auf die Gesamtmenge der polymeren Bindemittel.

Besonders geeignet als weitere Blockcopolymere sind die in der DE-C 22 15 090; der US-A 4,320,188; der US-A 4,197,130; der US-A 4,430,417 oder der US-A 4, 162,919 beschriebenen. Insbesondere lineare und radiale Blockcopolymere mit Polystyrolendblöcken wie z.B. Polystyrol-Polybutadien-Polystyrol, weitere (Polystyrol-Polybutadien)₄Si oder die entsprechenden Isoprenpolymere sind als Bindemittel geeignet, solange sie mit den erfindungswesentlichen Bindemitteln kompatibel sind. Besonders bevorzugt werden Polybutadien enthaltende Polymere verwendet. Das mittlere Molekulargewicht M_{w} der zusätzlichen Blockcopolymere liegt üblicherweise zwischen 10 000 und 300 000, bevorzugt zwischen 50 000 und 250 000. Ein Polystyrolanteil von 5 - 40 Gew.-% ist vorteilhaft, vor allem ein Gehalt von 5 - 30 Gew.-%.

Die erfindungsgemäßen Polymere können in einer oder mehreren photopolymerisierbaren Schichten photopolymerisierbarer Druckplatten verwendet werden. Auch die Kombination mit zusätzlichen Druckschichten, wie sie z. b. in der EP-B 0 084 851 beschrieben sind, ist möglich.

Als ethylenisch ungesättigte Verbindungen in den photopolymerisierbaren Gemischen bzw. Schichten werden die bekannten einfach oder mehrfach ungesättigten Monomere wie z.B. Ester oder Amide der Acrylsäure oder Methacrylsäure mit mono- oder polyfunktionellen Alkoholen, Aminen, Aminoalkoholen oder Hydroxyethern und -estern. Geeignet sind auch Mischungen aus mono- und polyungesättigten Verbindungen wie sie in der DE-C1 37 44 243 und der DE-A 36 30 474 beschrieben werden. Als Beispiele für die additionspolymersierbaren Verbindungen seien genannt: Butylacrylat, Isodecylacrylat, Tetradecylacrylat, Laurylacrylat, polyoxyethylierte Acrylate wie z. B. Polyoxyethylen-4-nonylphenolacrylat, 2-Hexyloxyethylacrylat, 1,4-Butandioldiacrylat, 1,6-Hexandioldiacrylat, Trimethylolpropantriacrylat und Dipentaerythritolmonohydroxypentacrylat, sowie die entsprechenden Methacrylate.

Desweiteren enthalten die photopolymerisierbaren Gemische bzw. Schichten einen der bekannten Photoinitiatoren oder ein Photoinitiatorsystem, z.B. Methylbenzoin, Benzoinacetat, Benzophenon, Benzil-dimethyl-ketal, Ethylanthrachinon/4,4'-Bis-(dimethylamino)-benzophenon.

Photopolymerisierbare Gemische oder Schichten gemäß der vorliegenden Erfindung enthalten allgemein 60 - 80 Gew.-% Bindemittel oder Bindemittelgemisch, 5 - 30 Gew.-% Monomer oder Monomermischung und 0,5 - 5 Gew.-% Initiator. Weitere Hilfsmittel wie z.B. Füllstoffe, Farbstoffe, Antioxidantien, Ozonschutzmittel, thermische Polymerisationsinhibitoren und Plastifizierungsmittel können in den üblichen Mengen enthalten sein. Bevorzugt werden 1 - 25 Gew.-% Plastifizierungsmittel zugesetzt. Die Dicke der photopolymerisierbaren Schichten beträgt 2.8 - 9.0 mm, bevorzugt 3.5 - 7.0 mm.

Als Schichtträger für die erfindungsgemäßen photopolymerisierbaren Druckplatten eignen sich z.B. Folien aus den verschiedensten filmbildenden synthetischen Polymeren. Bevorzugt werden Polyester und Polyester-Polyamid-Folien, die ggf. mit einer Haftschicht und/oder einer Antihaloschicht versehen sein können, verwendet, insbesondere Polyethylenterephthaltfolien.

Als Deckschicht können die hierfür üblichen Folien aus z.B. Polystyrol, Polyethylen, Polypropylen oder Polyethylenterephthalat verwendet werden.

Unter der Deckschicht befindet sich ggf. eine dünne nicht klebende, mit dem Entwicklerlösungsmittel entfernbare Polymerschicht. Bevorzugt verwendet werden Polyamide, Copolymere aus Ethylen und Vinylacetat oder ähnliche Polymere, die transparente und reißfeste Filme bilden. Die Schichtdicke beträgt 0,0025 bis 0,038 mm.

Die Herstellung erfindungsgemäßer photopolymerisierbarer Druckplatten erfolgt nach den üblichen Verfahren. Bevorzugt wird sie durch Extrudieren und anschließendes Kalandrieren der photopolymersierbaren Masse zwischen die Trägerschicht und ein Deckelement durchgeführt. Dieses Verfahren wird in der EP-B1 0 084 851 beschrieben. Das Deckelement kann lediglich aus einer Deckfolie bestehen oder zusätzlich noch aus einer elastomeren Schicht und/oder einer biegsamen Polymerschicht wie sie schon beschrieben wurden.

Die bildmäßige Belichtung der photopolymerisierbaren Druckplatte erfolgt nach allgemein üblichen Verfahren durch ein Negativ, wobei die Deckschicht der photopolymerisierbaren Druckplatte üblicherweise vor der bildmäßigen Belichtung entfernt wird.

Aktinische Strahlung beliebiger Herkunft und Art kann bei der Herstellung der flexographischen Druckformen benutzt werden. Geeignete Strahlungsquellen hierfür sind beispielsweise Quecksilberdampflampen, Glühlampen mit speziellen Leuchtstoffen, die Ultraviolettlicht emittieren, Argonglühlampen und Fotolampen. Am geeignetsten hiervon sind die Quecksilberdampflampen, insbesondere Ultraviolettlichtlampen und UV-Leuchtstofflampen.

Vor oder nach der bildmäßigen Belichtung kann eine vollflächige Rückseitenbelichtung durchgeführt werden. Diese Belichtung kann diffus oder gerichtet erfolgen. Als Belichtungsquellen können alle auch für die bildmäßige Belichtung üblichen Strahlungsquellen verwendet werden.

Das Auswaschen der nicht photopolymerisierten Bereiche der Druckplatte kann mit geeigneten Entwicklerlösungen, wie z. B. aliphatischen oder aromatischen Kohlenwasserstoffen wie n-Hexan, Petrolether, hydrierte Erdölfraktionen, Limonen oder anderen Terpenen oder Toluol, Isopropylbenzol, etc., Ketonen wie z.B.Methylethylketon, halogenierte Kohlenwasserstoffen wie Chloroform, Trichlorethan oder Tetrachlorethylen, Estern wie z.B. Essigsäure- oder Acetessigsäureester oder Gemischen der genannten Lösungsmittel, durchgeführt werden. Zusätze wie Tenside oder Alkohole sind möglich. Nach dem Trocknen können die so erhaltenen Druckformen zur Herstellung einer klebfreien Druckoberfläche in beliebiger Reihenfolge nachbelichtet und/oder chemisch bzw. physikalisch nachbehandelt werden.

Die folgenden Beispiele sollen die vorliegende Erfindung verdeutlichen. Die angegebenen Teile und Prozente beziehen sich, falls nichts anderes angegeben ist, auf das Gewicht. Die Bestimmung der mittleren Molekulargewichte M_{w}, der Molekulargewichtsverteilungen (M_{w}/Mₙ) und des Anteils der Diblockcopolymere erfolgte durch Gelpermeationschromatographie nach Lösen der Polymere in Tetrahydrofuran unter Verwendung von Polystyrol-Divinylbenzol-Säulen (200 - 3 000 000) und eines UV- (254 nm) bzw. RI-Detektors (37 °C) . Kalibriert wurde mit Polystyrolstandards mit mittleren Molekulargewichten M_{w} im Bereich 5050 - 1 033 000. Die Härte der Druckplatten bzw. -formen wurde als Shore A nach DIN 53.505 bestimmt. Zur Ermittlung der Photoempfindlichkeit wurden die Druckplatten a) 60 - 120 sec lang in 10 sec Schritten, b) 20 - 40 sec lang in 5 sec Schritten bzw. c) 50 - 650 sec lang in 150 sec Schritten von der Rückseite her vollflächig belichtet, ausgewaschen und getrocknet. Die jeweils verbliebenen Sockelhöhen wurden bestimmt.

### Beispiel 1

In einem Laborkneter (Werner & Pfleiderer, Typ LUK 025) wurden 70.13 Gew.-% eines radialen, ölverstreckten (31 Gew.-% Parafffinöl mit < 10 Gew.-% aromatische Verbindungen) (Polystyrol-Polybutadien)₄Si Blockcopolymeren mit einem mittleren Molekulargewicht M_{w} von 170 000, einer Molekulargewichtsverteilung (M_{w}/Mₙ) von 1.2, 30 Gew.-% Polystyrol und einem Diblockcopolymeregehalt von > 0 - 15 Gew.-%, 5.5 Gew.-% Hexamethylenglykoldiacrylat, 21.46 Gew.-% Polybutadien (M_{w} 3500), 1.0 Gew.-% polyethoxyliertes 4-Nonylphenolacrylat (4 Mol Ethylenoxid), 1.41 Gew.-% Irgacure 651, 0.5 Gew.-% 2,6-Di-tert.-butyl-4-methylphenol und 0.001 Gew.-% eines handelsüblichen Farbstoffs bei ca. 145°C verknetet. Nach Abkühlen der Schmelze wurde das Gemisch zwischen zwei Polyesterfolien in einer Laborpresse (140°C, 23 bar) zu photopolymerisierbaren Druckplatten verpreßt. Es wurden sowohl Platten mit einer Schichtdicke von 6.35 mm als auch solche mit Schichtdicken von 5.60 mm und 4.32 mm hergestellt. Von diesen Platten wurden die Rohhärten bestimmt. Anschließend wurden die Platten in der für photopolymere Flexodruckplatten üblichen Weise verarbeitet (d.h. belichtet, ausgewaschen mit FlexoSol® der Firma DuPont und nachbelichtet, wie in EP-B 0 084 851, Beispiel 1 beschrieben). Die Photoempfindlichkeiten und die Shore A Härten der Druckplatten bzw. der Druckformen sind in den Tabellen 1, 2, 3 und 4 zusammengestellt.

In Testdrucken wurde jeweils ein zweifarbiges Sujet gedruckt, das kritische Bildelemente enthielt, wie z. B. feine positive Linien (0.25 mm) und Raster (34 L/cm) sowie freistehende Punkte. Die erzielten Ergebnisse zeigten ein optimales Ausdrucken der Vollflächen und eine gute Wiedergabe der feinen Bildelemente ohne Waschbretteffekt. Alle weiteren Eigenschaften der Druckformen wurden nicht negativ beeinflußt. Entsprechende Tests mit vergleichbaren Ergebnissen wurden mit Materialien aus unterschiedlichen Ansätzen wiederholt.

### Vergleichsbeispiel

Wie in Beispiel 1 beschrieben wurde eine Druckplatte bzw. -form hergestellt verarbeitet und untersucht. Als Bindemittel wurde jedoch anstatt des erfindungsgemäßen Polymeren des Beispiels 1 ein lineares, ölverstrecktes (30 - 33 Gew.-% Weißöl) Polystyrol-Polybutadien-Polystyrol Blockcopolymer mit einem mittleren Molekulargewicht M_{w} von 190 000 und 31 Gew.-% Polystyrol verwendet. Die Plattendicke betrug 5.60 mm. Die Ergebisse sind in den Tabellen 3 und 4 zusammengestellt.

**Tabelle 1**

| Plattenempfindlichkeit nach a) | | | | | | | |
|---|---|---|---|---|---|---|---|
| Plattendicke 6.35 mm | | | | | | | |
| Rückseiten belichtung (sec) | 60 | 70 | 80 | 90 | 100 | 110 | 120 |
| [1.65J/min] | | | | | | | |
| Sockelhöhe (mm) | 3.55 | 3.85 | 4.04 | 4.28 | 4.43 | 4.47 | 4.77 |

**Tabelle 2**

| Plattenempfindlichkeit nach b) | | | | | |
|---|---|---|---|---|---|
| Plattendicke 4.32 mm | | | | | |
| Rückseiten belichtung (sec) | 20 | 25 | 30 | 35 | 40 |
| [1.65J/min] | | | | | |
| Sockelhöhe (mm) | 1.92 | 2.20 | 2.24 | 2.58 | 2.60 |

**Tabelle 3**

| Plattenempfindlichkeit nach c) | | | | | |
|---|---|---|---|---|---|
| Plattendicke 5.60 mm Rückseiten belichtung (sec) | 50 | 200 | 350 | 500 | 650 |
| [0.95J/min] | | | | | |
| Sockelhöhe (mm) | | | | | |
| Beispiel 1 | 1.75 | 2.69 | 3.58 | 3.99 | 4.17 |
| Vergleich | 1.19 | 1.56 | 1.88 | 2.08 | 2.20 |

**Tabelle 4**

| Shore A Härten | | | |
|---|---|---|---|
| | Härte (Shore A) | | |
| Plattendicke [mm] | Roh | Belichtet | Δ |
| 4.32 | 21.3 | 37.8 | 16.5 |
| 5.60 | 20.0 | 37.0 | 17.0 |
| Vergleich | 10.0 | 33.0 | 23.0 |
| 6.35 | 20.0 | 36.2 | 16.2 |

## Patentansprüche

1. Photopolymerisierbares Gemisch enthaltend
a) mindestens ein elastomeres Bindemittel,
b) mindestens eine photopolymerisierbare, ethylenisch ungesättigte Verbindung, c)mindestens einen Photoinitiator oder ein Photoinitiatorsystem,
**dadurch gekennzeichnet, dass**
es mindestens ein radiales (Polystyrol-Polybutadien)ₙX Blockcopolymer, mit X=Sn oder Si und n=4, enthält, das ein mittleres Molekulargewicht M_{w} von 80 000 - 300 000, eine Molekulargewichtsverteilung (M_{w}/Mₙ) von 1.00 - 1.40 und einen Diblockcopolymergehalt von >0 - 15 Gew.-% aufweist und mit >0 - 50 Gew.-% mindestens eines Paraffinöls verstreckt ist.

2. Photopolymerisierbares Gemisch gemäß Anspruch 1,
**dadurch gekennzeichnet, dass**
die Molekulargewichtsverteilung (M_{w}/Mₙ) 1.00 - 1.25 ist.

3. Photopolymerisierbares Gemisch gemäß Anspruch 1-2,
**dadurch gekennzeichnet, dass**
das radiale (Polystyrol-Polybutadien)ₙX Blockcopolymer ein mittleres Molekulargewicht M_{w} von 100 000 - 250 000 hat.

4. Photopolymerisierbares Gemisch gemäß Anspruch 1-3,
**dadurch gekennzeichnet, dass**
das radiale (Polystyrol-Polybutadien)ₙX Blockcopolymer mit 25 - 40 Gew.-% Paraffinöl verstreckt ist.

5. Photopolymerisierbares Gemisch gemäß Anspruch 1-4,
**dadurch gekennzeichnet, dass**
das Paraffinöl weniger als 10 Gew.-% aromatische Verbindungen enthält.

6. Photopolymerisierbares Gemisch gemäß Anspruch 1-5,
**dadurch gekennzeichnet, dass**
das radiale (Polystyrol-Polybutadien)ₙX Blockcopolymer einen Diblockcopolymeregehalt von >0 - 10 Gew.-% aufweist.

7. Photopolymerisierbares Gemisch gemäß Anspruch 1-6,
**dadurch gekennzeichnet, dass**
das radiale (Polystyrol-Polybutadien)ₙX Blockcopolymer das einzige polymere Bindemittel ist.

8. Photopolymerisierbares Gemisch gemäß Anspruch 1-7,
**dadurch gekennzeichnet, dass**
die Härte des nicht-photopolymerisierten Gemischs gemessen als Shore A Härte nach DIN 53.505 ≥ 20 ist.

9. Photopolymerisierbares Gemisch gemäß Anspruch 1-8,
**dadurch gekennzeichnet, dass**
die Härte des photopolymerisierten Gemischs gemessen als Shore A Härte nach DIN 53.505 ≤ 40, bevorzugt ≤ 38 ist.

10. Photopolymerisierbares Gemisch gemäß Anspruch 1-9,
**dadurch gekennzeichnet, dass**
die Differenz zwischen den Härten des photopolymerisierten Gemsichs und des nicht-photopolymerisierten Gemischs gemessen als Shore A Härten nach DIN 53.505 ≤ 22, bevorzugt ≤ 20 ist.

11. Photopolymerisierbare Druckplatte umfassend einen Schichtträger, mindestens eine photopolymerisierbare Schicht und ein Deckelement,
**dadurch gekennzeichnet, dass**
die photopolymerisierbare Schicht aus einem photopolymerisierbaren Gemisch gemäß Anspruch 1-10 besteht.

12. Photopolymerisierbare Druckplatte gemäß Anspruch 11,
**dadurch gekennzeichnet, dass**
zwischen der photopolymerisierbaren Schicht und dem Deckelement eine weitere polymere Schutzschicht vorhanden ist.

13. Flexographische Druckform herstellbar aus einer photopolymerisierbaren Druckplatte gemäß einem der Ansprüche 11 oder 12.

## Claims

1. Photopolymerizable composition comprising
a) at least one elastomeric binder,
b) at least one photopolymerizable, ethylenically unsaturated compound, and
c) at least one photoinitiator or a photoinitiator system,
**characterized in that**
it contains at least one radial (polystyrene-polybutadiene)ₙX block copolymer, with X=Sn or Si and n=4, with an average molecular weight M_{w} of 80000 - 300000, a molecular weight distribution (M_{w}/Mₙ) of 1.00 - 1.40 and a content of di-block copolymers of >0 - 15 % by weight, and which is extended with >0 - 50 % by weight of a paraffinic oil.

2. Photopolymerizable composition according to claim 1,
**characterized in that**,
the molecular weight distribution (M_{w}/Mₙ) is 1.00 - 1.25.

3. Photopolymerizable composition according to claim 1 to 2
**characterized in that**,
the radial (polystyrene-polybutadiene)ₙX block copolymer has an average molecular weight M_{w} of 100000 - 250000.

4. Photopolymerizable composition according to claim 1 to 3
**characterized in that**,
the radial (polystyrene-polybutadiene)ₙX block copolymer is extended with 25 - 40 % by weight of paraffinic oil.

5. Photopolymerizable composition to claim 1 to 4
**characterized in that**,
the paraffinic oil contains less than 10 % by weight of aromatic compounds.

6. Photopolymerizable composition according to claim 1 to 5
**characterized in that**,
the radial (polystyrene-polybutadiene)ₙX block copolymer has a content of di-block copolymers of >0 - 10 % by weight.

7. Photopolymerizable composition according to claim 1 to 6
**characterized in that**,
the radial (polystyrene-polybutadiene)ₙX block copolymer is the sole polymeric binder.

8. Photopolymerizable composition according to claim 1 to 7
**characterized in that**,
the durometer of the non-photopolymerized composition measured as Shore A according to DIN 53 505 is ≥ 20.

9. Photopolymerizable composition according to claim 1 - 8,
**characterized in that**,
the durometer of the photopolymerized composition measured as Shore A according to DIN 53 505 is ≤ 40, preferably ≤ 38.

10. Photopolymerizable composition according to claim 1 - 9,
**characterized in that**,
the difference between the durometer of the photopolymerized composition and the non-photopolymerized composition measured as Shore A according to DIN 53 505 is ≤ 22, preferably ≤ 20.

11. Photopolymerizable printing plate comprising a support, at least one photopolymerizable layer and a cover element,
**characterized in that**,
the photopolymerizable layer consists of a photopolymerizable composition according to claim 1 - 10.

12. Photopolymerizable printing plate according to claim 11,
a further polymeric layer exists between the photopolymerizable layer and the cover element.

13. Flexographic printing form prepared from a photopolymerizable printing plate according to claim 11 or 12.

## Revendications

1. Mélange photopolymérisable contenant
a) au moins un liant élastomère
b) au moins une liaison photopolymérisable éthyléniquement insaturée,
c) au moins un photoamorceur ou un système photoamorceur, **caractérisé en ce qu'**il contient au moins un copolymère bloc (polystyrène-polybutadiène)Xₙ radial, dans lequel X = Sn ou Si et n = 4, ayant un poids moléculaire moyen M_{w} compris entre 80000 et 300000, une répartition du poids moléculaire (M_{w}/Mₙ) comprise entre 1,00 et 1,40 et une teneur en copolymère dibloc de >0 à15% en poids et qu'il est étiré avec de >0 à 50% en poids d'au moins une huile de paraffine.

2. Mélange photopolymérisable selon la revendicaiton 1, **caractérisé en ce que** la répartition du poids moléculaire (M_{w}/Mₙ) est comprise entre 1,00 et 1,25.

3. Mélange photopolymérisable selon les revendications 1 et 2, **caractérisé en ce que** le copolymère bloc (polystyrène-polybutadiène)Xₙ radial a un poids moléculaire moyen compris entre 100000 et 250000.

4. Mélange photopolymérisable selon les revendications 1 à 3, **caractérisé en ce que** le copolymère bloc (polystyrène-polybutadiène)Xₙ radial est étiré avec 25 à 40% en poids d'huile de paraffine.

5. Mélange photopolymérisable selon les revendications 1 à 4, **caractérisé en ce que** l'huile de paraffine contient moins de 10% en poids de liaisons aromatiques.

6. Mélange photopolymérisable selon les revendications 1 à 5, **caractérisé en ce que** le copolymère bloc (polystyrène-polybutadiène)Xₙ radial a une teneur en copolymère dibloc de >0 à 10% en poids.

7. Mélange photopolymérisable selon les revendications 1 à 6, **caractérisé en ce que** le copolymère bloc (polystyrène-polybutadiène)Xₙ radial constitue le seul liant polymère.

8. Mélange photopolymérisable selon les revendications 1 à 7, **caractérisé en ce que** la dureté du mélange photopolymérisable, mesurée comme dureté Shore A selon la norme DIN 53.505 correspond à ≥ 20.

9. Mélange photopolymérisable selon les revendications 1 à 8, **caractérisé en ce que** la dureté du mélange photopolymérisable, mesurée comme dureté Shore A selon la norme DIN 53.505 correspond à ≤ 40, de préférence à ≤ 38.

10. Mélange photopolymérisable selon les revendications 1 à 9, **caractérisé en ce que** la différence entre les duretés du mélange photopolymérisable et du mélange non photopolymérisable, mesurées comme duretés Shore A selon la norme DIN 53.505 correspond à ≤ 22, de préférence à ≤ 20.

11. Plaque d'impression photopolymérisable comprenant un support, au moins une couche photopolymérisable et un élément de couverture, **caractérisée en ce que** la couche photopolymérisable est composée d'un mélange photopolymérisable selon les revendications 1 à 10.

12. Plaque d'impression photopolymérisable selon la revendication 11, **caractérisée en ce qu'**une couche de protection polymère additionnelle est agencée entre la couche photopolymérisable et l'élément de couverture.

13. Cliché flexographique pouvant être produit à partir d'une plaque d'impression photopolymérisable selon l'une des revendications 11 ou 12.
